# EUROPEAN PATENT SPECIFICATION

(11) **EP 3 255 358 B1**
(45) Date of publication and mention of the grant of the patent: **26.08.2020**
(21) Application number: 15880936.8
(22) Date of filing: 29.09.2015
(51) Int. Cl.: F25B 39/00, F25D 11/00, F28D 15/02, F28D 15/04, H01L 23/367, H01L 23/473, H01L 23/427

(54) **HEAT EXCHANGE APPARATUS AND SEMI-CONDUCTOR COOLING REFRIGERATOR PROVIDED WITH SAME**
WÄRMEAUSTAUSCHER UND HALBLEITERKÜHLER DAMIT
APPAREIL D'ÉCHANGE DE CHALEUR ET RÉFRIGÉRATEUR À REFROIDISSEMENT DE SEMI-CONDUCTEUR COMPRENANT CE DERNIER

(30) Priority: 03.02.2015 CN 201510056281
(43) Date of publication of application: 13.12.2017
(73) Proprietor: Qingdao Haier Joint Stock Co., Ltd, Qindao, Shandong 266101 (CN)
(72) Inventor: TAO, Haibo, Qingdao Shandong 266101 (CN); ZHANG, Kui, Qindao Shandong 266101 (CN); LIU, Jianru, Qindao Shandong 266101 (CN); LI, Peng, Qindao Shandong 266101 (CN); LI, Chunyang, Qindao Shandong 266101 (CN); QI, Feifei, Qindao Shandong 266101 (CN); JI, Lisheng, Qindao Shandong 266101 (CN)
(74) Representative: dompatent von Kreisler Selting Werner - Partnerschaft von Patent- und Rechtsanwälten mbB
(86) International application number: PCT/CN2015/091093
(87) International publication number: WO 2016/123994

(56) References cited:
- CN-A- 101 941 072
- CN-A- 102 510 990
- CN-A- 104 654 669
- CN-A- 104 654 670
- CN-U- 204 612 552
- JP-A- H11 257 882
- JP-A- 2010 060 164
- US-A- 5 803 161
- US-A1- 2004 069 461
- US-A1- 2007 025 078
- US-A1- 2012 186 787
- US-A1- 2012 192 574
- US-B1- 7 061 446

## Description

The present application claims the priority of the Chinese patent application No. 201510056281.7 filed on February 3, 2015 and with the title of "Heat Exchanging Apparatus and Refrigerator Having the Same".

### TECHNICAL FIELD

The present invention is related to a heat exchanging apparatus, and more particularly to a heat exchanging apparatus having a sintered heat pipe and a semiconductor refrigerator having the heat exchanging apparatus.

### BACKGROUND

A sintered heat pipe works in the principle that evaporation is utilized to cool a sintered heat pipe so that the temperature difference at the two ends of the heat pipe is quite large to quickly transfer heat. Thanks to their excellent heat transfer performance and other technical advantages, sintered heat pipes are widely used in the field of heat radiation. An existing sintered heat pipe extends from its one end to the other along an exclusive path, which may be linear, L-shaped or U-shaped. One end of the existing sintered heat pipe is an evaporating segment (or a heating segment), and the other end thereof is a condensing segment (or a cooling segment), and a heat insulating segment may be arranged between the evaporating and condensing segments according to the application needs. When one end of the sintered heat pipe is heated, the liquid in the capillary core is evaporated and vaporized. The vapors flow to the other end due to a slight pressure difference, emits heat and condenses into liquid again. Then, the liquid flows to the evaporating segment again under the capillary force along porous materials. This process cycles endlessly, transferring the heat from one end to the other end of the sintered heat pipe. Usually, a heat exchanging apparatus having such a sintered heat pipe is provided with fins on the condensing segment or the evaporating segment of the sintered heat pipe for radiating heat or transferring cold. However, existing heat exchanging apparatuses may not achieve desired effects when radiating heat for heat sources of a high heat flow density such as semiconductor cooling plates.

US2007/025078 A1 discloses a heat exchanging apparatus comprising a main pipe with a closed first end. The main pipe further comprises two second pipe segments with open ends. Further a fin group is provided comprising multiple corresponding fins which are arranged in parallel and with gaps therebetween. US 5 803 161 A discloses a heat exchanging apparatus according to the preamble of claim 1, with a heat pipe comprising a main pipe with two ends closed and further comprising a first pipe segment and several second tube segments with closed ends. US 2004/069461 A1 discloses heat exchanging apparatus with a heat pipe comprising a main pipe with two closed ends. The main pipe comprises a first pipe segment and several second pipe segments with closed ends. Further a fin group is provided comprising multiple corresponding fins which are arranged in parallel and with gaps therebetween, and the fin group being installed at the second pipe segment on the main pipe via pipe holes of the respective fins.

### SUMMARY

One object of a first aspect of the present invention is to overcome at least one defect of an existing heat exchanging apparatus by providing a novel heat exchanging apparatus.

A further object of the first aspect of the present invention is to improve the heat radiating or cold transferring efficiency of the heat exchanging apparatus so as to adapt to a heat or cold source of a high heat flow density.

One object of a second aspect of the present invention is to provide a semiconductor refrigerator having the heat exchanging apparatus.

The first aspect of the present invention provides a heat exchanging apparatus comprising one or more sintered heat pipes. In particular, each sintered heat pipe comprises a main pipe with both ends closed and having a first pipe segment and a second pipe segment, wherein the first pipe segment is configured to connect a heat or cold source, and one or more manifolds for radiating heat or transferring cold extend from one or more portions of the second pipe segment of the main pipe respectively. The heat exchanging apparatus further comprises one or two fin groups, each fin group comprising multiple corresponding fins which are arranged in parallel and with gaps therebetween, and each fin group being installed at the manifold on a corresponding side of the main pipe via the pipe holes of the respective fins.

Optionally, the first pipe segment of the main pipe is formed by extending from one end of the main pipe to the other end thereof by a predetermined length, and the second pipe segment of the main pipe is formed by extending from the other end of the main pipe to the one end thereof by a predetermined length.

Optionally, the first pipe segment of the main pipe is a straight pipe, and the first pipe segments of multiple main pipes are located in the same plane in parallel and with gaps therebetween.

Optionally, the heat exchanging apparatus further comprises: a fixed bottom plate whose one surface is provided with one or more grooves, and a fixed cover plate whose one surface is provided with one or more grooves and which is configured to cooperate with the fixed bottom plate to clamp the first pipe segment of the main pipe between the grooves of the fixed cover plate and of the fixed bottom plate.

Optionally, the second pipe segment of the main pipe is a straight pipe, and the second pipe segments of the multiple main pipes are located in the same plane in parallel and with gaps therebetween.

Optionally, the second pipe segment of the main pipe comprises a first straight pipe portion whose one end communicates with the corresponding first pipe segment, and a second straight pipe portion which extends from the other end of the first straight pipe portion perpendicularly relative to the first straight pipe portion and whose tail end is closed, wherein the first straight pipe portions of the second pipe segments of the multiple main pipes are located in the same plane in parallel and with gaps therebetween, and a starting end of a manifold of each sintered heat pipe is located at the first straight pipe portion of the corresponding second pipe segment.

Optionally, the projection of the manifold of each sintered heat pipe in a plane perpendicular to the corresponding first straight pipe portion overlaps with the projection of the corresponding second straight pipe portion in the plane.

Optionally, the manifolds of each sintered heat pipe are located at the same side of the corresponding main pipe, or the manifolds of each sintered heat pipe are located at the opposite sides of the corresponding main pipe respectively.

Optionally, the heat exchanging apparatus further comprises a blower arranged at the same side as the multiple manifolds and configured such that an air inlet area of the blower sucks air flow and the air flow is blown to a gap between each two adjacent fins, or the air flow is sucked from the gap between each two adjacent fins and is then blown to the air inlet area.

Optionally, the middle portion of each fin is provided with a receiving through hole so that each fin group defines a receiving space extending along the axes of the receiving through holes; the heat exchanging apparatus further comprises one or two blowers respectively provided in the receiving spaces of the corresponding fin groups and configured such that air flow is sucked from an air inlet area of each blower and is blown to a gap between each two adjacent fins of the corresponding fin group.

The second aspect of the present invention provides a semiconductor refrigerator comprising an inner tank, a semiconductor cooling plate and a heat exchanging apparatus, wherein the heat exchanging apparatus is configured to radiate heat from a hot end of the semiconductor cooling plate to ambient air or to transfer cold from a cold end of the semiconductor cooling plate to a storage compartment of the inner tank. In particular, the heat exchanging apparatus is any of the above heat exchanging apparatuses; the first pipe segment of the main pipe of each sintered heat pipe of the heat exchanging apparatus is connected to the hot or cold end of the semiconductor cooling plate; and the manifold of each sintered heat pipe is configured to radiate heat to ambient air or transfer cold to the storage compartment.

In the heat exchanging apparatus and the semiconductor refrigerator having the heat exchanging apparatus of the present invention, as multiple manifolds for radiating heat or transferring cold extend from the second pipe segment, the heat radiating or cold transferring efficiency of the heat exchanging apparatus and the semiconductor refrigerator is considerably improved, enabling the heat exchanging apparatus to adapt to heat/cold sources of a high heat flow density, such as semiconductor cooling plates, for radiating heat or transferring cold.

Further, thanks to the special structure of each sintered heat pipe in the heat exchanging apparatus and the semiconductor refrigerator having the heat exchanging apparatus of the present invention, the structures of the heat exchanging apparatus and the refrigerator are made more compact.

The above and other objects, advantages and features of the present invention will be understood by those skilled in the art more clearly with reference to the detailed description of the embodiments of the present below with reference to the accompanied drawings.

### BRIEF DESCRIPTION OF THE DRAWINGS

The followings will describe some embodiments of the present in detail in an exemplary rather than restrictive manner with reference to the accompanying drawings. The same reference signs in the drawings represent the same or similar parts. Those skilled in the art shall understand that these drawings are only schematic ones of this invention, and may not be necessarily drawn according to the scales. In the drawings:
Fig. 1 is a schematic front view of a heat exchanging apparatus according to an embodiment of the present invention;
Fig. 2 is a schematic left view of a heat exchanging apparatus according to an embodiment of the present invention;
Fig. 3 is a schematic front view of a heat exchanging apparatus according to the present invention;
Fig. 4 is a schematic front view of a heat exchanging apparatus according to a further embodiment of the present invention;
Fig. 5 is a schematic front view of a heat exchanging apparatus according to the further embodiment of the present invention;
Fig. 6 is a schematic view of a sintered heat pipe of a heat exchanging apparatus according to the further embodiment of the present invention;
Fig. 7 is a schematic right view of a semiconductor refrigerator according to an embodiment of the present invention; and
Fig. 8 is a schematic rear view of a semiconductor refrigerator according to an embodiment of the present invention.

Reference signs: 100-inner tank; 150-semiconductor cooling plate; 200-sintered heat pipe; 210-main pipe; 211-first pipe segment; 212-second pipe segment; 213-connecting pipe segment; 220-manifold; 310-fixed bottom plate; 320-fin group; 400-fin group; 410-fin; 500-blower; 2121-first straight pipe portion; 2122-second straight pipe portion.

### DETAILED DESCRIPTION

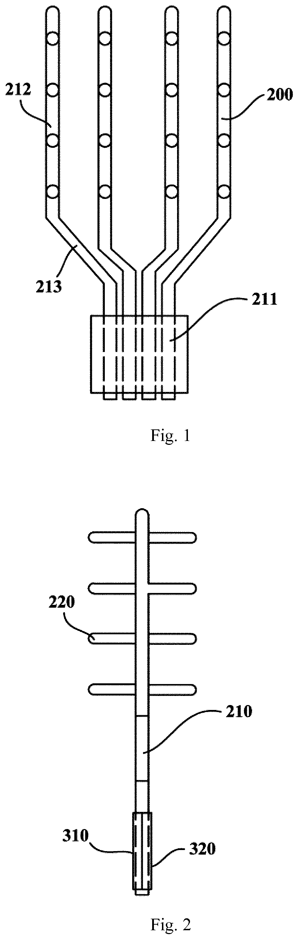

Fig. 1 is a schematic front view of a heat exchanging apparatus according to an embodiment of the present invention. As shown in Figs. 1-2, an embodiment of the present invention provides a heat exchanging apparatus, which is particularly suitable for radiating heat or transferring cold for a heat or cold source of a high heat flow density such as a semiconductor cooling plate 150, and may be applied in a semiconductor refrigerator. The heat exchanging apparatus may comprise one or more sintered heat pipes 200 to sufficiently utilize the heat conduction performance of the sintered heat pipes 200. In particular, each sintered heat pipe 200 comprises a main pipe 210 with both ends closed and having a first pipe segment 211 and a second pipe segment 212, wherein the first pipe segment 211 is configured to connect the heat or cold source. Preferably, one or more manifolds 220 for radiating heat or transferring cold extend from one or more portions of the second pipe segment 212 of the main pipe 210 respectively to improve the heat radiating or cold transferring efficiency of the heat exchanging apparatus.

In some embodiments of the present invention, the working chamber of the manifold 220 may communicate with the working chamber of the corresponding main pipe 210 to facilitate steam flow in the sintered heat pipe 200. The liquid absorbing core in the manifold 220 may be connected with the liquid absorbing core in the main pipe 210. The liquid absorbing cores in the manifold 220 and in the main pipe 210 closely contact the inner wall of the corresponding pipes respectively to facilitate flow of the working liquid. Further, the diameter of the manifold 220 may equal that of the main pipe 210. In some alternative embodiments of the present invention, the diameter of the manifold 220 may be smaller than that of the main pipe 210.

In some preferred embodiments of the present invention, As shown in Fig. 1, the first pipe segment 211 of the main pipe 210 is formed by extending from one end of the main pipe 210 to the other end thereof by a predetermined length, and the second pipe segment 212 of the main pipe 210 is formed by extending from the other end of the main pipe 210 to the one end thereof by a predetermined length.

For example, the first pipe segment 211 of the main pipe 210 may be a straight pipe, and the first pipe segments 211 of multiple main pipes 210 are located in the same plane in parallel and with gaps therebetween. The second pipe segment 212 of the main pipe 210 may be a straight pipe, and the second pipe segments 212 of multiple main pipes 210 are located in the same plane in parallel and with gaps therebetween. The first and second pipe segments 211, 212 of the main pipe 210 may be arranged to be parallel, and the main pipe 210 may include a connecting pipe segment 213 connected between the first and second pipe segments 211, 212 and arranged at an angle of 100°-170° relative to the first and second pipe segments 211, 212 respectively. The heat exchanging apparatus of the present invention may comprise four sintered heat pipes 200. The main pipes 210 of the four sintered heat pipes 200 are arranged in the same plane in symmetry with respect to a geometrical symmetry plane. The length of the connecting pipe segment 213 of one sintered heat pipe 200 at one side of the geometrical symmetry plane is smaller than that of the connecting pipe segment 213 of the other sintered heat pipe 200 at the same side of the geometrical symmetry plane, so that the four sintered heat pipes 200 are reasonably arranged.

To facilitate heat connection between the sintered heat pipe 200 and the heat source and the cold source and the fixing of the sintered heat pipe 200, the heat exchanging apparatus of the embodiments of the present invention further comprises a fixed bottom plate 310 and a fixed cover plate 320. One surface of the fixed bottom plate 310 is provided with one or more grooves, and the other surface thereof may press the hot end or cold end of the semiconductor cooling plate 150. In other words, the first pipe segment 211 of the sintered heat pipe 200 may be connected to the heat or cold source via the fixed bottom plate 310. One surface of the fixed cover plate 320 is also provided with one or more grooves, and the fixed cover plate 320 is configured to cooperate with the fixed bottom plate 310 to clamp the first pipe segment 211 of the main pipe 210 between the grooves of the fixed cover plate 320 and of the fixed bottom plate 310. After clamping the sintered heat pipe 200 between the fixed cover plate 320 and the fixed bottom plate 310, the three members are firmly fixed together by welding or mechanical squeezing. To effectively transfer heat, usually heat conducting silicone grease is coated on the contact surfaces between the sintered heat pipe 200 and the fixed bottom plate 310/the fixed cover plate 320.

In some embodiments of the present invention, the manifolds 220 of each sintered heat pipe 200 are located at the opposite sides of the corresponding main pipe 210 respectively. There are at least three manifolds 220 at each side of the main pipe 210. The starting ends of the manifolds 220 at each side of the main pipe 210 are arranged with equal gaps respectively along the extending direction of the main pipe 210. The numbers of the manifolds 220 at two sides of the main pipe 210 are the same. Each manifold at one side of the main pipe 220 is one the same line as the corresponding manifold 220 at the other side of the main pipe 210. As well-known by those skilled in the art, the manifolds 220 at one side of the main pipe 210 are arranged with gaps relative to the manifolds 220 at the other side of the main pipe 210. In some preferred embodiments of the present invention, the manifolds 220 of each sintered heat pipe 200 are located at the same side of the corresponding main pipe 210. Each manifold 220 extends outwards from a corresponding part of the corresponding main pipe 210 perpendicularly to a corresponding direction.

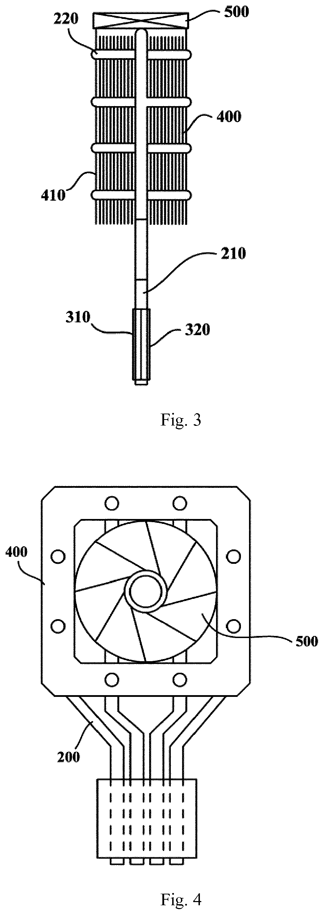

Fig. 3 is a schematic front view of a heat exchanging apparatus according to the present invention. The heat exchanging apparatus in the present embodiment of the present invention may comprise one or more fin groups 400, each fin group 400 comprising multiple corresponding fins 410 which are arranged in parallel and with gaps therebetween, and each fin group being installed at the manifold 220 on a corresponding side of the main pipe 210 via the pipe holes of the respective fins 410 to increase the heat radiating or cold transferring area. The heat exchanging apparatus may further comprise a blower 500 arranged at the same side as the multiple manifolds 220. For example, when the fins 410 are vertically arranged, the blower 500 may be arranged above the fin groups 400. The blower 500 may be configured such that an air inlet area of the blower sucks air flow and the air flow is blown to a gap between each two adjacent fins 410, or the air flow is sucked from the gap between each two adjacent fins 410 and is then blown to the air inlet area. Specifically, the blower 500 may be an axial flow blower 500 fixed on the fin groups 400. The rotary axis of the blades is perpendicular to each manifold 220.

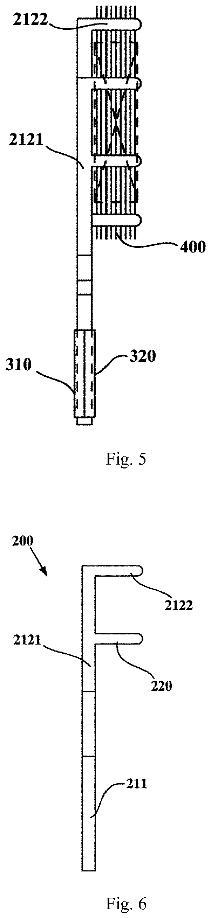

Fig. 4 is a schematic front view of a heat exchanging apparatus according to a further embodiment of the present invention. As shown in Figs. 4-6, the first pipe segment 211 of the main pipe 210 is a straight pipe, and the first pipe segments 211 of multiple main pipes 210 are located in the same plane in parallel and with gaps therebetween. The second pipe segment 212 of the main pipe 210 comprises a first straight pipe portion 2121 whose one end communicates with the corresponding first pipe segment 211, and a second straight pipe portion 2122 which extends from the other end of the first straight pipe portion 2121 perpendicularly relative to the first straight pipe portion 2121 and whose tail end is closed. The first straight pipe portions 2121 of the second pipe segments 212 of multiple main pipes 210 are located in the same plane in parallel and with gaps therebetween. The starting end of a manifold 220 of each sintered heat pipe 200 is located at the first straight pipe portion 2121 of the corresponding second pipe segment 212. The projection of the manifold 220 of each sintered heat pipe 200 in a plane perpendicular to the corresponding first straight pipe portion 2121 overlaps with the projection of the corresponding second straight pipe portion 2122 in the plane.

The heat exchanging apparatus may further comprise multiple fins 410 and multiple blowers 500. The multiple fins 410 are arranged in parallel and with gaps therebetween to form a fin group 400. The middle portion of each fin 410 is provided with a receiving through hole so that each fin group 400 defines a receiving space extending along the axes of the receiving through holes. The multiple blowers are respectively provided in the receiving spaces and configured such that air flow is sucked from an air inlet area of each blower and is blown to a gap between each two adjacent fins 410 of the corresponding fin group 400. The blower 500 is a centrifugal blower. The rotary axis of the blades overlaps with the axis of the receiving through hole, so that air flow is sucked from an axial direction of the centrifugal blower and is blown to the gap between each two adjacent fins 410 using a centrifugal force. The fin 410 is a plate whose middle part is provided with the receiving through hole and whose outer profile is rectangular. The fin group 400 may be installed on the second straight pipe portions 2122 of the main pipe via the pipe holes of the respective fins 410, respectively.

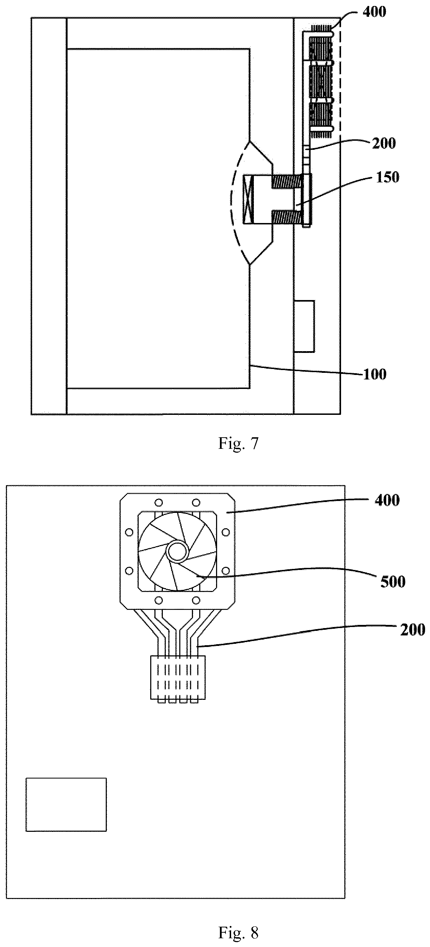

Fig. 7 is a schematic right view of a semiconductor refrigerator according to an embodiment of the present invention. As shown in Figs. 7-8, the present invention further provides a semiconductor refrigerator, comprising an inner tank 100, a semiconductor cooling plate 150 and a heat exchanging apparatus. The heat exchanging apparatus is configured to radiate heat from a hot end of the semiconductor cooling plate 150 to ambient air or to transfer cold from a cold end of the semiconductor cooling plate 150 to a storage compartment of the inner tank 100. In particular, the heat exchanging apparatus is the heat exchanging apparatus of any of the above embodiments. The first pipe segment 211 of the main pipe 210 of each sintered heat pipe 200 of the heat exchanging apparatus is connected to the hot or cold end of the semiconductor cooling plate 150. The manifold 220 of each sintered heat pipe 200 is configured to radiate heat to ambient air or transfer cold to the storage compartment. When the heat exchanging apparatus is a hot end heat exchanging apparatus, the first pipe segment 211 of the main pipe 210 of each sintered heat pipe 200 of the heat exchanging apparatus is connected to the hot end of the semiconductor cooling plate 150, and the second pipe segment 212 of the main pipe 210 of each sintered heat pipe 200 may be located above the first pipe segment 211. When the heat exchanging apparatus is a cold end heat exchanging apparatus, the first pipe segment 211 of the main pipe 210 of each sintered heat pipe 200 of the heat exchanging apparatus is connected to the cold end of the semiconductor cooling plate 150, and the second pipe segment 212 of the main pipe 210 of each sintered heat pipe 200 may be located below the first pipe segment 211.

## Claims

1. A heat exchanging apparatus, comprising one or more sintered heat pipes (200), wherein
each sintered heat pipe (200) comprises a main pipe (210) with both ends closed and having a first pipe segment and a second pipe segment, wherein the first pipe segment is configured to connect a heat or cold source, and
one or more manifolds (220) for radiating heat or transferring cold extend from one or more portions of the second pipe segment (212) of the main pipe (210) respectively, being **characterized in that** each heat pipe (200) further comprises
one or two fin groups (400), each fin group (400) comprising multiple corresponding fins (410) which are arranged in parallel and with gaps therebetween, and each fin group (400) being installed at the manifold (220) on the main pipe (210) via pipe holes of the respective fins (410).

2. The heat exchanging apparatus of claim 1, being **characterized in that**:
the first pipe segment (211) of the main pipe (210) is formed by extending from one end of the main pipe (210) to the other end thereof by a predetermined length, and
the second pipe segment (212) of the main pipe (210) is formed by extending from the other end of the main pipe (210) to the one end thereof by a predetermined length.

3. The heat exchanging apparatus of claim 1, being **characterized in that**: the first pipe segment (211) of the main pipe (210) is a straight pipe, and the first pipe segments (211) of multiple main pipes (210) are located in the same plane in parallel and with gaps therebetween.

4. The heat exchanging apparatus of claim 1, being **characterized by** further comprising:
a fixed bottom plate (310) whose one surface is provided with one or more grooves, and
a fixed cover plate (320) whose one surface is provided with one or more grooves, and the first pipe segment (211) of the main pipe (210) is clamped between the grooves of the fixed cover plate (320) and of the fixed bottom plate (310).

5. The heat exchanging apparatus of claim 1, being **characterized in that**: the second pipe segment (212) of the main pipe (210) is a straight pipe, and the second pipe segments (212) of the multiple main pipes (210) are located in the same plane in parallel and with gaps therebetween.

6. The heat exchanging apparatus of claim 1, being **characterized in that**: the second pipe segment (212) of the main pipe (210) comprises a first straight pipe portion (2121) whose one end communicates with the corresponding first pipe segment (211), and a second straight pipe portion (2122) which extends from the other end of the first straight pipe portion (2121) perpendicularly relative to the first straight pipe portion (2121) and whose tail end is closed, wherein the first straight pipe portions (2121) of the second pipe segments (212) of the multiple main pipes (210) are located in the same plane in parallel and with gaps therebetween, and a starting end of a manifold (220) of each sintered heat pipe (200) is located at the first straight pipe portion (2121) of the corresponding second pipe segment (212).

7. The heat exchanging apparatus of claim 6, being **characterized in that**: the projection of the manifold (220) of each sintered heat pipe (200) in a plane perpendicular to the corresponding first straight pipe portion (2121) overlaps with the projection of the corresponding second straight pipe portion (2122) in the plane.

8. The heat exchanging apparatus of claim 1, being **characterized in that**: the manifolds (220) of each sintered heat pipe (200) are located at the same side of the corresponding main pipe (210), or the manifolds (220) of each sintered heat pipe (200) are located at the opposite sides of the corresponding main pipe (210) respectively.

9. The heat exchanging apparatus of claim 1, being **characterized by** further comprising: a blower (500) arranged at the same side as the multiple manifolds (220) and an air inlet area of the blower (500) is set towards a gap between each two adjacent fins (410), or an air outlet area of the blower (500) is set towards the gap between each two adjacent fins (410).

10. The heat exchanging apparatus of claim 1, being **characterized in that**: the middle portion of each fin (410) is provided with a receiving through hole so that each fin group (400) defines a receiving space extending along the axes of the receiving through holes; and
the heat exchanging apparatus further comprises one or two blowers (500) respectively provided in the receiving spaces of the corresponding fin groups (400) and configured such that air flow is sucked from an air inlet area of each blower (500) and is blown to a gap between each two adjacent fins (410) of the corresponding fin group (400).

11. A semiconductor refrigerator comprising an inner tank (100), a semiconductor cooling plate (150) and a heat exchanging apparatus, wherein the heat exchanging apparatus is configured to radiate heat from a hot end of the semiconductor cooling plate (150) to ambient air or to transfer cold from a cold end of the semiconductor cooling plate (150) to a storage compartment of the inner tank (100), the semiconductor refrigerator being **characterized in that**:
the heat exchanging apparatus is the heat exchanging apparatus according to any of claims 1-10;
the first pipe segment (211) of the main pipe (210) of each sintered heat pipe (200) of the heat exchanging apparatus is connected to the hot or cold end of the semiconductor cooling plate (150); and
the manifold (220) of each sintered heat pipe (200) is configured to radiate heat to ambient air or transfer cold to the storage compartment.

## Patentansprüche

1. Wärmetauschvorrichtung mit einem oder mehreren gesinterten Wärmerohren (200), bei welcher
jedes gesinterte Wärmerohr (200) ein Hauptrohr (210) aufweist, dessen beide Enden geschlossen sind und das ein erstes Rohrsegment und ein zweites Rohrsegment aufweist, wobei das erste Rohrsegment zum Anschließen einer Wärme- oder Kältequelle ausgebildet ist, und
ein oder mehrere Verteiler (220) zum Abstrahlen von Wärme oder zum Übertragen von Kälte sich jeweils von einem oder mehreren Bereichen des zweiten Rohrsegments (212) des Hauptrohrs (200) erstrecken,
**dadurch gekennzeichnet, dass** jedes Wärmerohr (200) ferner aufweist:
eine oder zwei Rippengruppen (400), wobei jede Rippengruppe (400) mehrere entsprechende Rippen (410) aufweist, die parallel und mit Zwischenräumen zwischen einander angeordnet sind, und wobei jede Rippengruppe (400) an dem Verteiler (220) auf dem Hauptrohr (210) über Rohrlöcher der jeweiligen Rippen (400) angebracht ist.

2. Wärmetauschvorrichtung nach Anspruch 1, **dadurch gekennzeichnet, dass**:
das erste Rohrsegment (211) des Hauptrohrs (210) gebildet ist, indem es sich von einem Ende des Hauptrohrs (210) zu dessen anderen Ende über eine vorbestimmte Länge erstreckt, und
das zweite Rohrsegment (212) des Hauptrohrs (210) gebildet ist, indem es sich vom anderen Ende des Hauptrohrs (210) zu seinem einen Ende um eine vorbestimmte Länge erstreckt.

3. Wärmetauschvorrichtung nach Anspruch 1, **dadurch gekennzeichnet, dass**:
das erste Rohrsegment (211) des Hauptrohrs (210) ein gerades Rohr ist und
die ersten Rohrsegmente (211) mehrerer Hauptrohre (210) in derselben Ebene parallel und mit Zwischenräumen zwischen einander angeordnet sind.

4. Wärmetauschvorrichtung nach Anspruch 1, **dadurch gekennzeichnet, dass** sie ferner aufweist:
eine feste Bodenplatte (300), deren eine Fläche mit einer oder mehreren Rillen versehen ist, und
eine feste Abdeckplatte (320), deren eine Fläche mit einer oder mehreren Rillen versehen ist, und wobei das erste Rohrsegment (211) des Hauptrohrs (210) zwischen den Rillen der festen Abdeckplatte (320) und der festen Bodenplatte (310) geklemmt ist.

5. Wärmetauschvorrichtung nach Anspruch 1, **dadurch gekennzeichnet, dass**:
das zweite Rohrsegment (212) des Hauptrohrs (210) ein gerades Rohr ist und die zweiten Rohrsegmente (212) der mehreren Hauptrohre (210) in derselben Ebene parallel und mit Zwischenräumen zwischen einander angeordnet sind.

6. Wärmetauschvorrichtung nach Anspruch 1, **dadurch gekennzeichnet, dass**:
das zweite Rohrsegment (212) des Hauptrohrs (210) einen ersten geraden Rohrbereich (2121) aufweist, dessen eines Ende mit dem entsprechenden ersten Rohrsegment (211) in Verbindung steht, und einen zweiten geraden Rohrbereich (2122), der sich von dem anderen Ende des ersten geraden Rohrbereichs (2121) senkrecht zu dem ersten geraden Rohrbereich (2121) erstreckt und dessen hinteres Ende geschlossen ist, wobei die ersten geraden Rohrbereiche (2121) der zweiten Rohrsegmente (212) der mehreren Hauptrohre (210) in derselben Ebene parallel und mit Zwischenräumen zwischen einander angeordnet sind, und ein Anfangsende eines Verteilers (220) jedes gesinterten Wärmerohrs (200) sich an dem ersten geraden Rohrbereich (2121) des entsprechenden zweiten Rohrsegments (212) befindet.

7. Wärmetauschvorrichtung nach Anspruch 6, **dadurch gekennzeichnet, dass**:
die Projektion des Verteilers (220) jedes gesinterten Wärmerohrs (200) in einer Ebene senkrecht zu dem entsprechenden ersten geraden Rohrbereich (2121) mit der Projektion des entsprechenden zweiten geraden Rohrbereichs (2122) in der Ebene überlappt.

8. Wärmetauschvorrichtung nach Anspruch 1, **dadurch gekennzeichnet, dass**:
die Verteiler (220) jedes gesinterten Wärmerohrs (200) auf derselben Seite des entsprechenden Hauptrohrs (210) angeordnet sind oder die Verteiler (220) jedes gesinterten Wärmerohrs (200) sich jeweils auf den gegenüberliegenden Seiten des entsprechenden Hauptrohrs (210) befinden.

9. Wärmetauschvorrichtung nach Anspruch 1, **dadurch gekennzeichnet, dass** sie ferner aufweist:
ein Gebläse (500), das auf derselben Seite wie die mehreren Verteiler (220) angeordnet ist, und wobei ein Lufteinlassbereich des Gebläses (500) in Richtung eines Zwischenraums zwischen jeweils zwei benachbarten Rippen (410) eingestellt ist oder ein Luftauslassbereich des Gebläses (500) in Richtung des Zwischenraums zwischen jeweils zwei benachbarten Rippen (410) eingestellt ist.

10. Wärmetauschvorrichtung nach Anspruch 1, **dadurch gekennzeichnet, dass**:
der mittlere Abschnitt jeder Rippe (410) mit einem Aufnahmedurchgangsloch versehen ist, so dass jede Rippengruppe (400) einen Aufnahmeraum bildet, der sich entlang der Achsen der Aufnahmedurchgangslöcher erstreckt; und
die Wärmetauschvorrichtung ferner ein oder zwei Gebläse (500) aufweist,
die jeweils in den Aufnahmeräumen der entsprechenden Rippengruppen (400) vorgesehen sind und derart ausgebildet sind, dass der Luftstrom aus einem Lufteinlassbereich jedes Gebläses (500) angesaugt und zu einem Zwischenraum zwischen jeweils zwei benachbarten Rippen (410) der entsprechenden Rippengruppe (400) geblasen wird.

11. Halbleiterkühlschrank mit einem Innentank (100), einer Halbleiterkühlplatte (150) und eine Wärmetauschvorrichtung, wobei die Wärmetauschvorrichtung dazu ausgebildet ist, Wärme von einem warmen Ende der Halbleiterkühlplatte (150) an die Umgebungsluft abzustrahlen oder Kälte von einem kalten Ende der Halbleiterkühlplatte (150) zu einem Lagerfach des Innentanks zu übertragen, wobei der Halbleiterkühlschrank **dadurch gekennzeichnet ist, dass**:
die Wärmetauschvorrichtung die Wärmetauschvorrichtung nach einem der Ansprüche 1 bis 10 ist;
das erste Rohrsegment (211) des Hauptrohrs (210) jedes gesinterten Wärmerohrs (200) der Wärmetauschvorrichtung mit dem warmen oder kalten Ende der Halbleiterkühlplatte (150) verbunden ist; und
der Verteiler (220) jedes gesinterten Wärmerohrs (200) derart ausgebildet ist, dass er Wärme an die Umgebungsluft abstrahlt oder Kälte in das Lagerfach überträgt.

## Revendications

1. Appareil d'échange de chaleur, comprenant un ou plusieurs tubes caloporteurs frittés (200), dans lequel
chaque tube caloporteur fritté (200) comprend un tube principal (210) avec les deux extrémités fermées et ayant un premier segment de tube et un second segment de tube, dans lequel le premier segment de tube est configuré pour raccorder une source de chaleur ou de froid, et
un ou plusieurs répartiteurs (220) pour propager de la chaleur ou transférer du froid s'étendent depuis une ou plusieurs portions du second segment de tube (212) du tube principal (210) respectivement,
**caractérisé en ce que** chaque tube caloporteur (200) comprend en outre
un ou deux groupes d'ailettes (400), chaque groupe d'ailettes (400) comprenant de multiples ailettes (410) correspondantes qui sont agencées en parallèle et avec des écartements entre elles, et chaque groupe d'ailettes (400) étant installé au niveau du répartiteur (220) sur le tube principal (210) via des trous de tube des ailettes (410) respectives.

2. Appareil d'échange de chaleur selon la revendication 1, **caractérisé en ce que** :
le premier segment de tube (211) du tube principal (210) est formé en s'étendant d'une extrémité du tube principal (210) à son autre extrémité sur une longueur prédéterminée, et
le second segment de tube (212) du tube principal (210) est formé en s'étendant de l'autre extrémité du tube principal (210) à sa première extrémité sur une longueur prédéterminée.

3. Appareil d'échange de chaleur selon la revendication 1, **caractérisé en ce que** : le premier segment de tube (211) du tube principal (210) est un tube droit, et les premiers segments de tube (211) de multiples tubes principaux (210) sont situés dans le même plan en parallèle et avec des écartements entre eux.

4. Appareil d'échange de chaleur selon la revendication 1, **caractérisé en ce qu'**il comprend en outre :
une plaque de dessous fixe (310) dont une surface est pourvu d'une ou de plusieurs rainures, et
une plaque de couverture fixe (320) dont une surface est pourvue d'une ou de plusieurs rainures, et le premier segment de tube (2100) du tube principal (210) est serré entre les rainures de la plaque de couverture fixe (320) et de la plaque de dessous fixe (310).

5. Appareil d'échange de chaleur selon la revendication 1, **caractérisé en ce que** : le second segment de tube (212) du tube principal (210) est un tube droit, et les seconds segments de tube (212) des multiples tubes principaux (210) sont situés dans le même plan en parallèle et avec des écartements entre eux.

6. Appareil d'échange de chaleur selon la revendication 1, **caractérisé en ce que** : le second segment de tube (212) du tube principal (210) comprend une première portion de tube droit (2121) dont une extrémité communique avec le premier segment de tube (211) correspondant, et une seconde portion de tube droit (2122) qui s'étend depuis l'autre extrémité de la première portion de tube droit (2121) perpendiculairement par rapport à la première portion de tube droit (2121) et dont l'extrémité arrière est fermée, dans lequel les premières portions de tube droit (2121) des seconds segments de tube (212) des multiples tubes principaux (210) sont situées dans le même plan en parallèle et avec des écartements entre elles, et une extrémité de départ d'un répartiteur (220) de chaque tube caloporteur fritté (200) est située au niveau de la première portion de tube droit (2121) du second segment de tube (212) correspondant.

7. Appareil d'échange de chaleur selon la revendication 6, **caractérisé en ce que** : la saillie du répartiteur (220) de chaque tube caloporteur fritté (200) dans un plan perpendiculaire à la première portion de tube droit (2121) correspondante chevauche la saillie de la seconde portion de tube droit (2122) correspondante dans le plan.

8. Appareil d'échange de chaleur selon la revendication 1, **caractérisé en ce que** : les répartiteurs (220) de chaque tube caloporteur fritté (200) sont situés au niveau du même côté du tube principal (210) correspondant, ou les répartiteurs (220) de chaque tube caloporteur fritté (200) sont situés au niveau des côtés opposés du tube principal (210) correspondant respectivement.

9. Appareil d'échange de chaleur selon la revendication 1, **caractérisé en ce qu'**il comprend en outre : une soufflante (500) agencée au niveau du même côté que les multiples répartiteurs (220) et une zone d'entrée d'air de la soufflante (500) est placée vers un écartement entre deux ailettes (410) adjacentes, ou une zone de sortie d'air de la soufflante (500) est placée vers l'écartement entre deux ailettes (410) adjacentes.

10. Appareil d'échange de chaleur selon la revendication 1, **caractérisé en ce que** : la portion médiane de chaque ailette (410) est pourvue d'un trou traversant de réception de sorte que chaque groupe d'ailettes (400) définisse un espace de réception s'étendant le long des axes des trous traversants de réception ; et
l'appareil d'échange de chaleur comprend en outre une ou deux soufflantes (500) prévues respectivement dans les espaces de réception des groupes d'ailettes (400) correspondants et configurées de sorte qu'un flux d'air soit aspiré depuis une zone d'entrée d'air de chaque soufflante (500) et soit soufflé vers un écartement entre deux ailettes (410) adjacentes du groupe d'ailettes (400) correspondant.

11. Réfrigérateur à semi-conducteur comprenant un réservoir interne (100), une plaque de refroidissement semi-conducteur (150) et un appareil d'échange de chaleur, dans lequel l'appareil d'échange de chaleur est configuré pour propager de la chaleur d'une extrémité chaude de la plaque de refroidissement semi-conducteur (150) à l'air ambiant ou pour transférer du froid d'une extrémité froide de la plaque de refroidissement semi-conducteur (150) à un compartiment de stockage du réservoir interne (100), le réfrigérateur à semi-conducteur étant **caractérisé en ce que** :
l'appareil d'échange de chaleur est l'appareil d'échange de chaleur selon l'une quelconque des revendications 1 à 10 ;
le premier segment de tube (211) du tube principal (210) de chaque tube caloporteur fritté (200) de l'appareil d'échange de chaleur est raccordé à l'extrémité chaude ou froide de la plaque de refroidissement semi-conducteur (150) ; et
le répartiteur (220) de chaque tube caloporteur fritté (200) est configuré pour propager de la chaleur à l'air ambiant ou transférer du froid au compartiment de stockage.
